# NEUE EUROPÄISCHE PATENTSCHRIFT

(11) **EP 3 342 043 B2**
(45) Veröffentlichungstag und Bekanntmachung des Hinweises auf die Entscheidung über den Einspruch: **18.10.2023**
(45) Hinweis auf die Patenterteilung: 07.04.2021
(21) Anmeldenummer: 16794550.0
(22) Anmeldetag: 02.11.2016
(51) Int. Cl.: H03K 17/96, H03K 17/967

(54) **EINGABEGERÄT MIT REDUNDANTER DETEKTION**
INPUT DEVICE HAVING REDUNDANT DETECTION
APPAREIL D'ENTRÉE À DÉTECTION REDONDANTE

(30) Priorität: 04.11.2015 DE 102015118863; 31.03.2016 DE 102016105846
(43) Veröffentlichungstag der Anmeldung: 04.07.2018
(73) Patentinhaber: Preh GmbH, 97616 Bad Neustadt a. d. Saale (DE)
(72) Erfinder: MENNINGER, Stefan, 97076 Würzburg (DE); ERNST, Martin, 97631 Bad Königshofen (DE); LUST, Matthias, 97456 Dittelbrunn (DE); KLEIN, Markus, 97616 Salz (DE)
(74) Vertreter: Lohmanns, Bernard
(86) Internationale Anmeldenummer: PCT/EP2016/076389
(87) Internationale Veröffentlichungsnummer: WO 2017/076881

(56) Entgegenhaltungen:
- DE-A1-102011 106 786
- DE-A1-102012 203 831
- US-A1- 2011 057 899

## Beschreibung

Die Vielfalt der vorbekannten Eingabegeräte ist nicht zuletzt aufgrund der unterschiedlichsten Bedienkonzepte groß. So unterscheiden sich die Eingabegeräte in der praktischen Verwendung in ihren Anforderungen betreffenden die Funktionssicherheit, nachfolgend auf "funktionale Sicherheit" genannt, welche sich aus den durch sie vorgenommenen Schalt- und Steuerfunktionen und/oder aufgrund ihrer Anordnung ergeben. So werden beispielsweise an ein Eingabegerät zur Bedienung einer Fahrzeuggeschwindigkeitsregelanlage regelmäßig höhere Anforderungen gestellt, als an ein solches Eingabegerät, welches eine Komfortfunktion des Fahrzeugs steuert.

Darüber hinaus können sich aber schon alleinig durch die Anordnung eines Eingabegerät höhere Anforderungen ergeben, wie zum Beispiel bei einem Eingabegerät mit mehreren benachbarten Eingabeflächen, auch Schaltflächen genannt, die beispielsweise jeweils Teil einer geschlossenen Oberfläche sind. Schon in so einem Fall besteht grundsätzlich Bedarf, die Bedienung oder Betätigung einer Eingabefläche zu verifizieren, um Fehlbedienungen zu vermeiden. Insbesondere ein erhöhter Bedarf besteht, wenn beide Situationen zusammenkommen, dass einerseits die durch das betreffende Eingabegerät zu steuernde Funktion sicherheitsrelevant ist und andererseits die Betätigung bzw. Berührung dieses Eingabegeräts zu verifizieren, um beispielsweise die Funktionsauslösung durch unbeabsichtigte Berührung bzw. Betätigung zu unterdrücken. Die letztere Konstellation kann von besonderer Bedeutung sein, wenn mehrere Eingabeflächen dicht gedrängt angeordnet, hinsichtlich ihrer jeweiligen Fläche vergleichsweise klein sind und/oder in unmittelbarer Nähe einer Grifffläche angeordnet sind.

Aus der EP 2977872 A1 ist ein Touchpad bekannt, bei dem zur Steigerung der Bediensicherheit zwei kapazitive, jeweils eine Berührung detektierende Einrichtungen vorgesehen sind. Eine mit einer Betätigung in Zusammenhang stehende Betätigungskraft wird nicht detektiert. Aus der DE 10 2012 203 831 A1 ist eine Eingabeanordnung bekannt, bei der eine Erfassungsvorrichtung zur Umsetzung einer Berührungseingabe vorgesehen ist. Gattungsgmäße Eingabegeräte sind aus der US 2010/0053116 A1, der US 2013/0018489 A1 sowie der US 9,158,407 B2 bekannt. Vor diesem Hintergrund besteht die der Erfindung zugrunde liegende Aufgabe nun darin, ein Eingabegerät bereitzustellen, dessen funktionale Sicherheit verbessert ist, wobei insbesondere dieses Eingabegerät konstruktiv einfach und bauraumsparend realisierbar ist. Diese Aufgabe wird durch ein Eingabegerät gemäß Anspruch 1 gelöst. Vorteilhafte Ausgestaltungen sind jeweils Gegenstand der abhängigen Ansprüche. Es ist darauf hinzuweisen, dass die in den Ansprüchen einzeln aufgeführten Merkmale in beliebiger, technologisch sinnvoller Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Die Erfindung betrifft ein Eingabegerät, welches mehrere Eingabeflächen definiert. Erfindungsgemäß sind mehrere Detektionseinrichtungen vorgesehen, die jeweils ausgelegt sind, unabhängig voneinander eine Berührung der Eingabefläche auf der Eingabefläche oder eine Betätigung der Eingabefläche zu detektieren. Die Begriffe Berührung und Betätigung sind weit auszulegen, als Berührung wird beispielsweise ein kraftloses aber nicht zwingend kraftloses Anschmiegen oder angrenzendes Anordnen eines Eingabemittels, beispielsweise eine Fingers oder einer Fingerkuppe eines Bedieners, an die Eingabefläche verstanden. Als Betätigen wird eine mit einer Betätigungskraft auf die Eingabefläche einhergehende Einwirkung eines Eingabemittels, wie eines Fingers oder einer Fingerkuppe eines Bedieners, verstanden. Bezüglich der zugehörigen Detektionseinrichtungen ist die Erfindung ebenfalls nicht eingeschränkt. Bevorzugt handelt es sich bei wenigstens einer der mehreren Detektionseinrichtung um eine solche, die ausgelegt ist, ausschließlich die Detektion der Berührung zu detektieren und die nachfolgend als Berührdetektionseinrichtung bezeichnet wird. Damit ist eine Detektionseinrichtung gemeint, die ausgelegt ist, eine Berührung zu detektieren und die nicht in der Lage ist, eine Betätigungskraft zu detektieren, d.h. eben nicht ein Maß oder eine Richtung der Krafteinwirkung messen zu können. Wohingegen eine ortsauflösende Berührdetektion nicht ausgeschlossen sein soll und gemäß einer bevorzugten Ausgestaltung vorgesehen ist. Die Berührdetektionseinrichtung weist beispielsweise einen optischen oder kapazitiven Berührsensor auf. Ein kapazitiver Berührsensor definiert wenigstens eine Messkapazität, deren Beeinflussung bei Berührung der Eingabefläche durch den Berührsensor detektiert wird. Beispielsweise weist jeder Berührsensor eine zugehörige, elektrisch isolierte, eine Messkapazität erzeugende Elektrode auf. Bei den erfindungsgemäß vorgesehenen, mehreren kapazitiv detektierenden Berührdetektionseinrichtungen sind mehrere elektrisch isoliert zueinander angeordnete ringförmige oder streifenförmige Elektroden vorgesehen. Die Elektroden sind enfindungsemäß gemäß ihrer Zugehörigkeit zu den Berührdetektionseinrichtungen in der Ausdehnungsrichtung der Eingabefläche alternierend angeordnet, beispielsweise auf einer gemeinsamen Seite einer Schicht oder auf unterschiedlichen Seiten einer Schicht oder auf unterschiedlichen Schichten eines Schichtaufbaus. Erfindungsgemäß erfolgt die Überwachung jeweils ein und derselben Eingabefläche durch die die Berührung detektierenden Detektionseinrichtungen und die die Betätigung detektierende Detektionseinrichtung.

Beispielsweise kann jede der zur jeweiligen kapazitiv detektierenden Berührdetektionseinrichtung gehörenden Elektrodenstruktur als eine PCAP-(Projective Capacitive-) Sensor-Schicht ausgebildet sein. Die PCAP Sensor-Schicht umfasst zwei parallel angeordnete Ebenen mit leitfähigen Mustern, bevorzugt Linien oder Streifen, die isoliert voneinander angebracht sind. Diese Ebenen bilden einen Kondensator, dessen Kapazität sich durch Berührung ändert, wodurch messbare Ströme an den Anschlüssen des leitfähigen Musters hervorgerufen werden. Die PCAP-Technik bietet den Vorteil, dass damit auch mehrere Berührungen gleichzeitig oder Gesten erkennbar sind, wofür sich auch die Bezeichnung "Multi-Touch" durchgesetzt hat.

Erfindungsgemäß ist ferner eine Auswerteinheit vorgesehen, die ausgelegt ist, ausschließlich bei Detektion durch wenigstens zwei der Detektionseinrichtungen dem Eingabegerät bei Betätigung oder Berührung eine Schalt- oder Steuerfunktion zuzuordnen. Hierbei kann eine hinreichende Übereinstimmung im Detektionssignal als eine gemeinsame Detektion durch wenigstens zwei Detektionseinrichtungen verstanden werden. Bezüglich wenigstens einer Eingabefläche genügt das Eingabegerät somit den Anforderungen der "funktionalen Sicherheit", was durch die erfindungsgemäß zweifach redundante Auslösung, d.h. durch zumindest doppelte Detektion durch zwei unabhängig voneinander detektierende Detektionseinrichtungen erreicht wird. Darunter wird verstanden, dass die wenigstens zwei Detektionseinrichtungen unabhängig voneinander in der Lage sein sollen, detektionsabhängig ein dem Detektionsergebnis entsprechendes Signal zu erzeugen, dass jeweils der Auswerteinheit zur weiteren Verarbeitung zugeführt wird. Während eine teilweise gemeinsame Nutzung von beispielsweise das Messsignal aufarbeitenden Datenverarbeitungseinrichtungen auf dem Signalweg zwischen Detektionseinrichtung und Auswerteinheit der erfindungsgemäßen Lehre der unabhängigen Detektion entgegenstehen würde, würde die gemeinsame Nutzung gewisser Eingangskomponenten der Detektionseinrichtungen, beispielsweise Elektroden, nicht zwingend einer redundanten Auslegung im Sinne der Erfindung entgegen stehen würde.

Beispielsweise ist die Auswerteinheit mittels zueinander isolierter Datenleitungen zur Übertragung des zugehörigen Detektionsergebnisses mit den mehreren Detektionseinrichtungen elektrisch verbunden. Die Signale der beiden Detektionseinrichtungen werden erfindungsgemäß von der Auswerteinheit ausgewertet. Nur bei übereinstimmenden Signalen, d.h. beide Signale weisen auf die Betätigung bzw. Berührung ein und derselben Eingabefläche hin, wird die entsprechende Schaltfunktion ausgelöst.

Erfindungsgemäß ist wenigstens eine der Detektionseinrichtungen als eine auf die Detektion der Betätigung ausgerichtete Detektionseinrichtung ausgebildet, und wird nachfolgend als Betätigungsdetektionseinrichtung bezeichnet. Unter einer Betätigungsdetektionseinrichtung wird eine solche Detektionseinrichtung verstanden, die in der Lage ist, ein Maß oder eine Richtung der Betätigungskrafteinwirkung messen oder detektieren zu können. Dabei wird unter Messung der Krafteinwirkung beispielsweise eine absolute Messung aber auch eine solche Detektion verstanden, die eine einen vorgegebenen Schwellenwert überschreitende Krafteinwirkung voraussetzt. Durch die zwingende Detektion einer Betätigung durch die Betätigungsdetektionseinrichtung können unbeabsichtigte Berührungen der Eingabefläche von zielgerichteten Betätigungen der Eingabefläche unterschieden werden und nur letzteren eine Schalt- oder Steuerfunktion zugeordnet werden. Es hat sich gezeigt, dass eine solche Betätigungsdetektionseinrichtung vergleichsweise bauraumsparend in ein bestehendes Eingabegerätekonzept integrierbar ist. Es hat sich gezeigt, dass durch eine die Betätigungskraft detektierende Einrichtung, die Bediensicherheit nicht nur besonders effektiv steigern lässt sondern auch eine Paarung einer solchen auf die Detektion einer Betätigungskraft ausgerichteten Detektionseinrichtung mit weiteren Detektionseinrichtung besonders bauraumsparend realisierbar ist.

Gemäß einer bevorzugten Ausgestaltung sind die wenigstens zwei Detektionseinrichtungen auch noch diversitär ausgelegt, d.h. unterscheiden sich in der physikalischen Arbeitsweise ihrer Detektion und/oder im Messverfahren. Beispielsweise ist eine optische oder kapazitive, die jeweilige Eingabefläche überwachende Berührdetektionseinrichtung vorgesehen, während ferner eine dieselbe Eingabefläche erfassende, die Betätigungskraft induktiv oder resistiv messende Betätigungsdetektionseinrichtung vorgesehen ist.

Als Kraftsensor für die Betätigungsdetektionseinrichtung ist beispielsweise wenigstens ein piezoelektrischer Kraftsensor vorgesehen. Gemäß einer bevorzugten Ausgestaltung ist vorgesehen, dass die Betätigungsdetektionseinrichtung wenigstens einen kapazitiven, resistiven und/oder optischen Kraftsensor aufweist. Bevorzugt weist wenigstens eine der mehreren Detektionseinrichtungen eine Matrix von Kraftsensoren auf. Als eine Matrix wird auch eine Anordnung von genau zwei Kraftsensoren verstanden. Beispielsweise sind mehrere Eingabeflächen, deren Anordnung der Matrix entspricht, vorgesehen, wobei jedem Kraftsensor eine der Eingabeflächen zugeordnet ist. Alternativ sind mehrere Kraftsensoren der einen Eingabefläche zugeordnet, um so die Betätigung, genauer deren Einwirkort auf der Eingabefläche ortsauflösend zu detektieren.

Die Matrix von Kraftsensoren ist beispielsweise auf einer gemeinsamen Leiterplatte angeordnet. Die Matrix von Kraftsensoren wird beispielsweise durch einen gemeinsamen Folienschichtaufbau definiert.

Bevorzugt ist die Matrix von Kraftsensoren ausgelegt, eine Richtung und/oder einen Einwirkort der Betätigungskraft zu detektieren. Bei dieser bevorzugten Ausführungsform ist die Auswerteinheit ausgelegt, in Abhängigkeit der Richtung und/oder des Einwirkortes der Betätigungskraft dem Eingabegerät eine richtungsspezifische und/oder einwirkortspezifische Schalt- oder Steuerfunktion zuzuordnen.

Bevorzugt ist wenigstens die eine Detektionseinrichtung, die ausgelegt ist, die Betätigung zu detektieren, ferner dazu ausgelegt, bei gleichzeitiger Betätigung an mehreren Einwirkorten die Einwirkorte zu detektieren und somit in der Lage, den Einwirkort betreffende Daten an die Auswerteinheit zu übermitteln. Darüber hinaus ist dabei die Auswerteinheit ausgelegt, in Abhängigkeit der verschiedenen Einwirkorte der Betätigungskraft dem Eingabegerät eine spezifische Schalt- oder Steuerfunktion aus mehreren Schalt- oder Steuerfunktionen zuzuordnen. Dadurch kann eine Multifunktionalität erreicht werden und gleichzeitig die Bediensicherheit gesteigert werden. Bevorzugt ist dabei die weitere oder die weiteren Detektionseinrichtungen beispielsweise die zusätzliche Berührdetektionseinrichtung ebenfalls ausgelegt, im Falle einer gleichzeitigen Berührung an mehreren Einwirkorten, jeweils ein einwirkortspezifisches Detektionsergebnis an die Auswerteinheit zu übermitteln, so dass auch bezüglich der einwirkortspezifischen Detektion eine redundante Detektion durchgeführt wird.

Gemäß einer weiteren bevorzugten Ausgestaltung weist das erfindungsgemäße Eingabegerät eine Haptikeinrichtung zur Erzeugung einer haptischen Rückmeldung auf und die Auswerteinheit ist ausgelegt, im Fall, dass wenigstens eine der Detektionseinrichtungen, bevorzugt wenigstens zwei der Detektionseinrichtungen, eine Berührung und/oder eine Betätigung detektieren, eine haptische Rückmeldung durch die Haptikeinrichtung zu bewirken. Beispielsweise ist im Gehäuse des Eingabegerät ferner die Haptikeinrichtung angeordnet und elektrisch leitend mit der Auswerteinheit verbunden, um eine haptische Rückmeldung mittels eines auf die Eingabefläche wirkenden Aktors, beispielsweise mittels eines elektromotorischen Aktors, zu bewirken.

Bevorzugt ist ferner eine Funktionsüberwachungseinrichtung zur Überwachung der Funktion einer oder mehrerer, bevorzugt aller, Detektionseinrichtungen vorgesehen.

Bevorzugt weisen die mehreren Detektionseinrichtungen einen gemeinsamen Sender zur Erzeugung eines oder mehrerer Detektionssignale, beispielsweise eines optischen Signals auf, und die Funktionsüberwachungseinrichtung umfasst einen Empfänger für das eine oder die mehreren Detektionssignale.

Die Erfindung betrifft ferner ein Lenkrad, welches ein an dem Lenkrad befestigtes Eingabegerät in einer der zuvor beschriebenen Ausgestaltungen aufweist. Beispielsweise handelt es sich bei dem Eingabegerät um einen sogenannten Multifunktionsschalter im Lenkrad.

Die Erfindung betrifft ferner die Verwendung des Eingabegeräts in einer der zuvor beschriebenen Ausführungsformen in einem Kraftfahrzeug, insbesondere zur Steuerung eines Geschwindigkeitsregelanlage, auch Tempomat oder Cruisecontrol genannt.

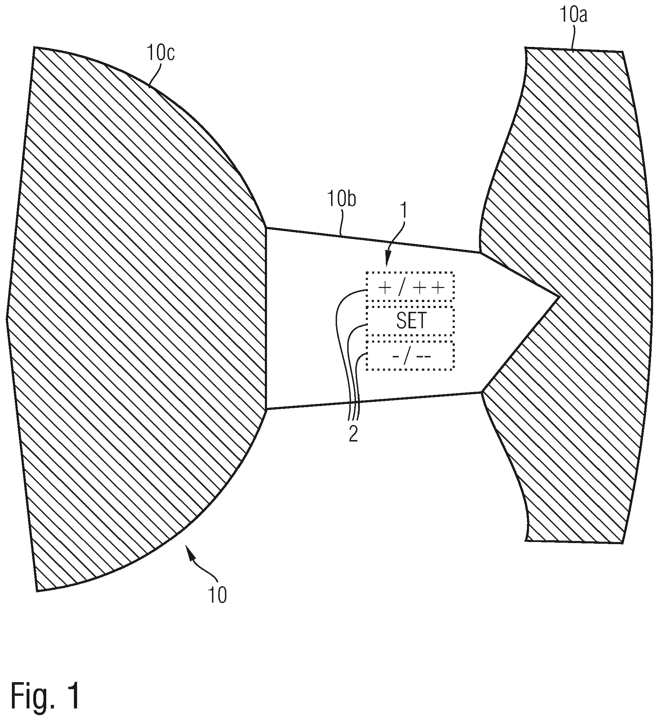

Figur 1 zeigt im Teilausschnitt ein erfindungsgemäßes Lenkrad 10, welches einen äußeren, einen Griffbereich definierenden Lenkradkranz 10a, einen Pralltopf 10c und eine oder mehrere die vorgenannten Komponenten verbindende Lenkradspeichen 10b aufweist. In die Lenkradspeiche 10b ist auf der dem nicht dargestellten Fahrer zugewandten Seite eine Eingabegerät 1 in einer der erfindungsgemäßen Ausführungsformen integriert. Dieses Eingabegerät 1 dient der Funktionseingabe und Steuerung einer nicht dargestellten Geschwindigkeitsregelanlage. Dazu definiert das Eingabegerät 1 drei in Reihe angeordnete, auf der dem Fahrer zugewandten Seite der Lenkradspeiche 10b angeordnete Eingabeflächen 2, denen unterschiedliche Steuerfunktionen zugeordnet sind.

Wie nachfolgend erläutert wird, ist es erfindungsgemäß vorgesehen, dass jeder dieser Eingabeflächen 2 wenigstens zwei, in der Figur 1 nicht dargestellte Detektionseinrichtungen zugeordnet sind, die jeweils ausgelegt sind, unabhängig voneinander eine Berührung und/oder Betätigung zu detektieren und das Detektionsergebnis an eine in Figur 1 nicht dargestellte Auswerteinheit zu übermitteln. Diese Auswerteinheit ist ausgelegt, ausschließlich bei hinreichender Übereinstimmung der Detektionssignals aller der betreffenden Eingabefläche 2 zugeordneten Detektionseinrichtung, der Berührung bzw. Betätigung dieser Eingabefläche 2 eine Schalt- oder Steuerfunktion zuordnet. Erfindungsgemäß ist wenigstens eine Detektionseinrichtung als Betätigungsdetektionseinrichtung ausgebildet, so dass diese in der Lage ist, eine über eine Berührung hinausgehende Betätigung anhand der Betätigungskraft zu detektieren. Dadurch können Fehlbedienungen vermieden, insbesondere aber Funktions- oder Schaltauslösungen durch unbeabsichtigtes Berühren sicherer ausgeschlossen werden.

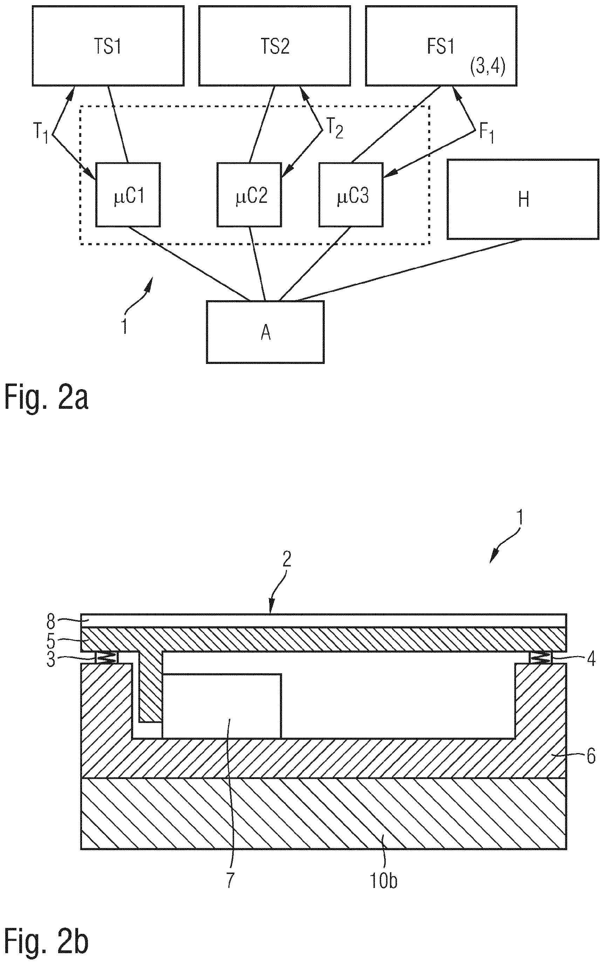

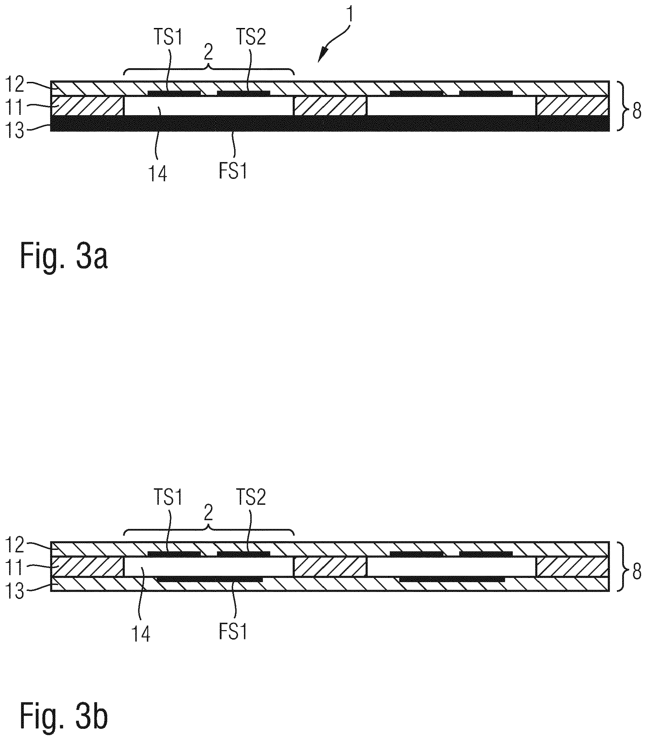

Anhand der Figur 2a wird eine erfindungsgemäße Ausführungsform eines redundanten Aufbaus des Eingabegeräts 1 erläutert, wobei vorliegend eine dreifache Redundanz gewählt ist. Es sind zwei Berührdetektionseinrichtungen T1 und T2 vorgesehen, die jeweils einen Berührsensor, jeweils in Form kapazitiver Elektroden TS1 bzw. TS2 und eine zugehörige Signalaufbereitungseinrichtung, beispielsweise mit Analog-nach-Digital-Wandlern µC1 bzw. µC2 aufweisen. Die unabhängig voneinander detektierenden Berührdetektionseinrichtungen T1 und T2 erzeugen zugehörige Detektionssignale, die über isolierte elektrische Datenleitungen an eine Auswerteinheit A übertragen werden, die beispielsweise nicht in dem in Figur 1 gezeigten Lenkrad 10, sondern beispielsweise im Armaturenbrett angeordnet ist. Zusätzlich ist ferner eine Betätigungsdetektionseinrichtung F1 vorgesehen. Diese umfasst wenigstens einen Kraftsensor FS1, beispielsweise zwei Kraftsensoren 3, 4, deren Auslegung und Platzierung später anhand der Figur 2b bis 2f, 3a und 3b erläutert werden. Die Betätigungsdetektionseinrichtung F1 umfasst ferner auch eine zugehörige eigene Signalaufbereitungseinrichtung, beispielsweise mit Analog-nach-Digital-Wandler, µC3. Im Falle einer hinreichenden Übereinstimmung aller durch die Detektionseinrichtungen T1, T2 und F1 bereitgestellten Detektionsergebnisse wird durch die Auswerteinheit A nicht nur eine Schalfunktion vorgenommen, sondern auch eine Erzeugung einer haptischen Rückmeldung durch eine Haptikeinrichtung H initiiert, die beispielsweise mittels eines nicht dargestellten elektromagnetischen Aktuators eine Stoß- oder Schwingungsbewegung der betreffenden Eingabefläche 2 der Figur 1 anregt.

Der prinzipielle Aufbau einer Ausführungsform des nicht-erfindungsgemäßen Eingabegeräts 1 wird anhand der Schnittdarstellung der Figur 2b erläutert. Das Gehäuse 6 des Eingabegeräts 1 ist starr an der in Figur 1 gezeigten Lenkradspeiche 10b befestigt. Ein die Eingabefläche 2 oder mehrere Eingabeflächen definierender Schichtaufbau 8 ist auf einem Träger 5 aufgebracht, der seinerseits beweglich gegenüber dem Gehäuse 6 gelagert ist. Zwischen dem Träger 5 und dem Gehäuse 6 sind dazu elastische Lagermittel 3, 4 vorgesehen. Diese Lagermittel 3, 4 sind in einer einfachen Ausgestaltung ebenfalls als Kraftsensoren, beispielsweise als piezoelektrische Kraftsensoren, ausgebildet. Es ist ferner eine einen elektromotorischen Aktor 7 umfassende Haptikeinrichtung H vorgesehen, um im Falle eines übereinstimmenden Detektionsergebnisses aller Detektionseinrichtungen, wie zuvor in Bezug auf Figur 2a erwähnt, den Träger 5 parallel und/oder senkrecht zur Eingabefläche 2 sich bewegend anzutreiben, um so ein haptisches Feedback für einen auf der Eingabefläche 2 ruhenden Finger zu erzeugen.

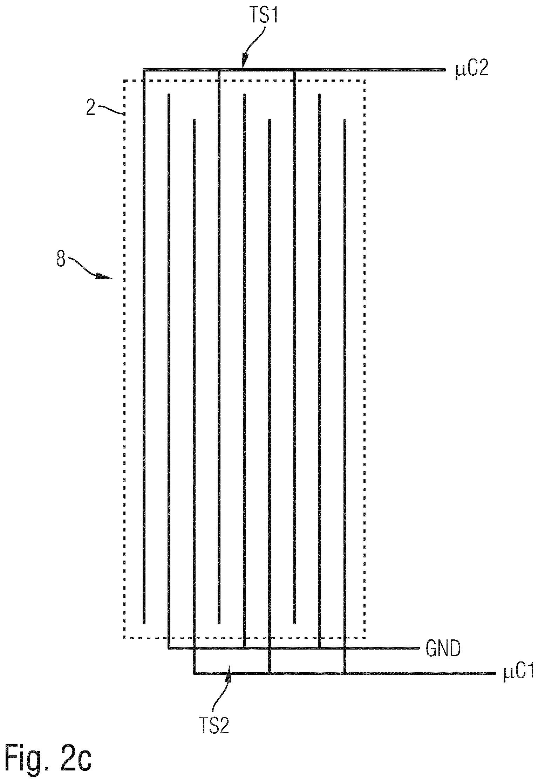

Die Figuren 2c bis 2f zeigen unterschiedliche erfindungsgemäß mögliche Ausführungsformen, die die zumindest teilweise Integration der kapazitiven Berührdetektionseinrichtungen T1 und T2, insbesondere deren Elektroden TS1 und TS2 in den in Figur 2b gezeigten Schichtaufbau 8 zum Ziel haben. Es ist jeweils eine Aufsicht auf den Schichtaufbau 8 und die dadurch definierte Eingabefläche 2 gezeigt. Gemeinsamer Aspekt dieser Ausführungsformen ist, dass die Elektroden TS1 und TS2 nicht auf einer gemeinsamen Seite einer Schicht des Schichtaufbaus 8, sondern auf unterschiedlichen Schichten des Schichtaufbaus 8 oder zumindest auf unterschiedlichen Seiten einer Schicht aufgebracht sind. Figur 2c zeigt in schematischer Aufsicht auf die Eingabefläche 2 eine Ausführungsform, bei der die streifenförmigen Elektroden TS1 und TS2 kammartig ausgebildet sind und alternierend versetzt zueinander angeordnet sind, um so eine effektive Bedeckung der Eingabefläche 2 mit den Elektroden TS1, TS2 zu ermöglichen. Eine dritte kammartige, mit den anderen Strukturen alternierend "verwebte" Elektrodenstruktur GND liegt auf Erdpotenzial und dient der Abschirmung. An den äußeren Enden sind die Elektroden mit den zugehörigen Signalaufbereitungseinrichtungen µC1 bzw. µC2 verbunden.

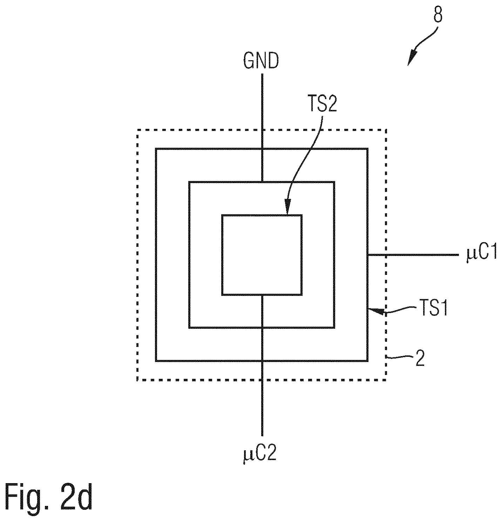

Die Figur 2d zeigt eine Ausführungsform bei der die zueinander isolierten Elektroden TS1, TS2 der zwei unabhängigen, kapazitiven Berührdetektionseinrichtungen sowie eine als Abschirmung vorschaltete Elektrode GND als zueinander konzentrisch angeordnete, alternierend angeordnete Ringe ausgebildet sind.

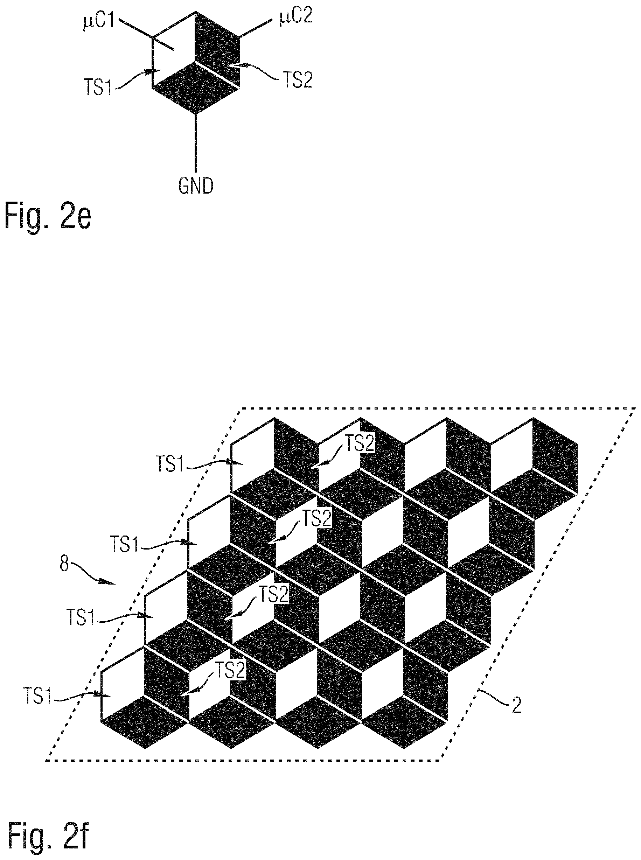

Die Figuren 2e und 2f repräsentieren eine Ausführungsform, bei der die zueinander isolierten Elektroden TS1, TS2 der zwei unabhängigen, kapazitiven Berührdetektionseinrichtungen sowie eine zur Abschirmung vorgesehen Elektrode GND als aus einem sich periodisch wiederholenden Grundmuster, auch "Elementarzelle" genannt, aufgebaut ist, wobei das in Figur 2e gezeigte Grundmuster sich seinerseits aus Teilmustern, beispielsweise aus Rhombus-förmigen Teilmustern, aller beteiligter Elektroden TS1, TS2 und GND zusammensetzt, die einzelnen Teilmuster jedoch auf unterschiedlichen Schichten des Schichtaufbaus 8 vorgesehen sind. Durch eine derartige Elektrodenstruktur wird eine PCAP- (Projective Capacitive) Sensor-Schicht ausgebildet, die eine einwirkortauflösende Detektion bei gleichzeitiger Berührung an mehreren Einwirkorten gestattet.

In den Figuren 3a und 3b sind Ausführungsformen des Schichtaufbaus 8 in Schnittdarstellung gezeigt, die neben der Integration von Teilen der kapazitiven Berührdetektionseinrichtungen T1 und T2, nämlich deren Elektroden TS1 und TS2, auch eine Integration von Teilen der kapazitiven Betätigungsdetektionseinrichtung F1, nämlich deren Elektrode FS1 vorsieht. Damit entfällt die in Figur 2b gezeigte Anordnung der Kraftsensoren 3, 4 zwischen dem Träger 5 und dem Gehäuse 6 zugunsten einer integrierten Anordnung von Teilen der Betätigungsdetektionseinrichtung T1, hier der Elektrode FS1, in den Schichtaufbau 8, nämlich in der Ausführungsform der Figur 3a als untere, d.h. dem Bediener abgewandte, elektrisch leitende Grundschicht 13. In der vorliegenden Ausgestaltung ist die Trägerschicht 12 elastisch verformbar ausgestaltet und erstreckt sich über einen durch die Abstandsschicht 11 definierten Hohlraum 14, der unterhalb der Eingabefläche 2 angeordnet ist und nach oben durch die Trägerschicht 12 und die dort auf der dem Hohlraum 14 zugewandten Seite aufgebrachten Elektroden TS1 und TS2 begrenzt wird. Während die Elektroden TS1 bzw. TS2 der kapazitiven redundanten Berührdetektion durch die Berührdetektionseinrichtungen T1 bzw. T2 dienen, dienen diese Elektroden TS1 und TS2 in Zusammenwirken mit der Elektrode FS1 der Erzeugung einer Messkapazität, wobei die durch die Betätigung verursachte Verformung der Trägerschicht 12 und die dadurch bewirkte Veränderung der Messkapazität ein Maß für die Betätigungskraft ist, welche durch die kapazitive Betätigungsdetektionseinrichtung F1 gemessen wird.

In Figur 3b ist eine Ausführungsform gezeigt, bei der die der kapazitiven Betätigungsdetektionseinrichtung F1 zugehörige Elektrode FS1 als eine Beschichtung der Grundschicht 13 und zwar auf der dem Hohlraum 14 zugewandten Seite der Grundschicht 13 ausgebildet ist.

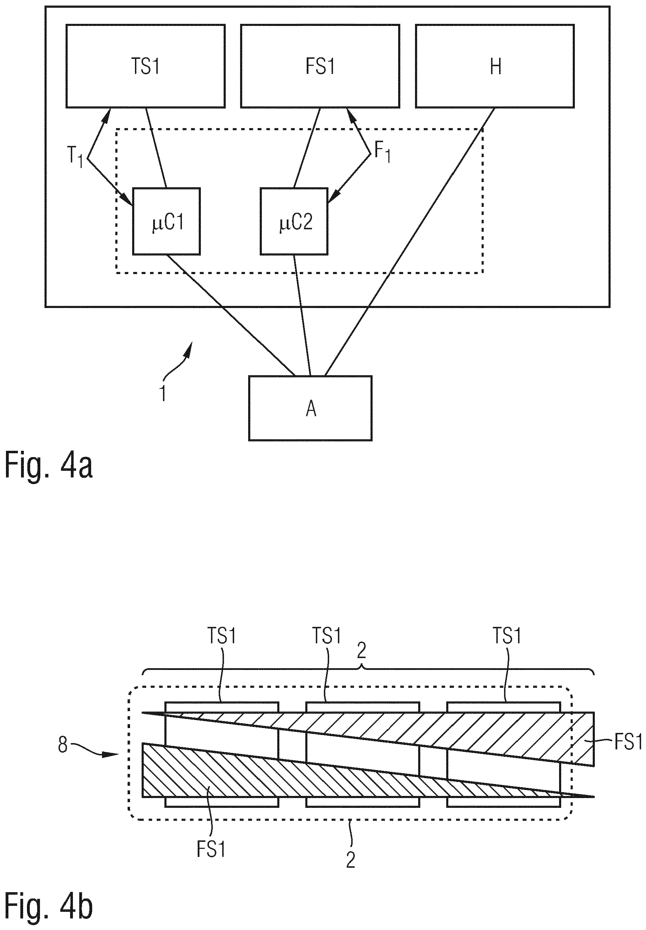

Anhand der Figur 4a wird eine weitere Ausführungsform des nicht-erfindungsgemäßen Eingabegeräts 1 vorgestellt, welches zweifach redundant ausgelegt ist und im Vergleich zur Ausführungsform der Figur 2a auf eine doppelte Berührdetektion verzichtet und die redundante Detektion sich daraus ergibt, dass neben einer Berührdetektionseinrichtung T1 eine Betätigungsdetektionseinrichtung F1 vorgesehen ist. Auch diese Ausgestaltung des Eingabegeräts 1 ist, wie in Figur 1 gezeigt, bevorzugt in einem Lenkrad 10 angeordnet.

Auch bei dieser Ausführungsform wird, wie Figur 4b schematisch in einer Aufsicht auf die durch den Schichtaufbau 8 definierte Eingabefläche 2 zeigt, die Integration der Sensoren TS1, hier Elektroden für die kapazitive Berührdetektion, und der Kraftsensoren FS1, hier Spulen zur induktiven Betätigungsdetektion, in den die Eingabefläche 2 definierenden Schichtaufbau 8 vorgeschlagen.

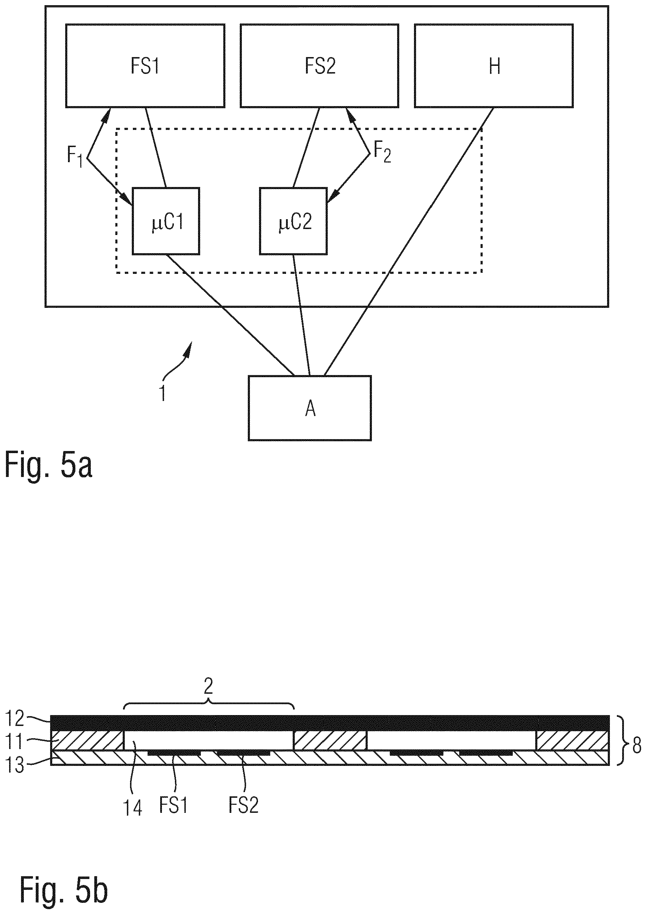

Anhand der Figur 5a wird eine weitere nicht-erfindungsgemäße Ausführungsform erläutert, die im Vergleich zur Ausführungsform der Figur 2a ganz auf eine Berührdetektion verzichtet und ganz auf eine redundante Betätigungsdetektion durch zwei unabhängig voneinander detektierenden Betätigungsdetektionseinrichtungen F1 und F2 setzt, wobei auch hier die Auswerteinheit A das Detektionsergebnis dieser Betätigungsdetektionseinrichtungen dahingehend wechselseitig verifiziert, dass nur dann eine Schalt- oder Funktionsauslösung der Betätigung der Eingabefläche zugeordnet wird, wenn eine hinreichende gleichzeitige Übereinstimmung der Detektionsergebnisse vorliegt. Auch diese Ausgestaltung des Eingabegeräts 1 ist, wie in Figur 1 gezeigt war, bevorzugt in einem Lenkrad angeordnet.

Wie bei den vorherigen Ausgestaltungen, könnte die zugehörigen Sensoren, wie in Figur 2b gezeigt, zwischen dem Träger 5 und dem Gehäuse 6 angeordnet sein. Bevorzugt ist aber auch bei dieser Ausführungsform die Integration der zugehörigen Sensoren, hier der Elektroden für eine kapazitive Detektion oder alternativ Leiterbahnen FS1 und FS2 für eine resistive Detektion in den die Eingabefläche 2 definierenden Schichtaufbau 8, wie in Figur 5b gezeigt. In der vorliegenden Ausgestaltung ist die elektrisch leitende Trägerschicht 12 elastisch verformbar ausgestaltet und erstreckt sich über einen durch die Abstandsschicht 11 definierten Hohlraum 14, der unterhalb der Eingabefläche 2 angeordnet ist und nach unten durch die Grundschicht 13 und die dort auf der dem Hohlraum 14 zugewandten Seite aufgebrachten Leiterbahnen FS1 und FS2 begrenzt wird. Bei Einwirkung einer Betätigungskraft im Bereich der Eingabefläche 2 kommt es zu einer Verformung der Trägerschicht 12 und bei deren ausreichender Annäherung an die Grundschicht 13 zu einem detektierbaren elektrischen Strom, der ein Maß für die Betätigungskraft darstellt.

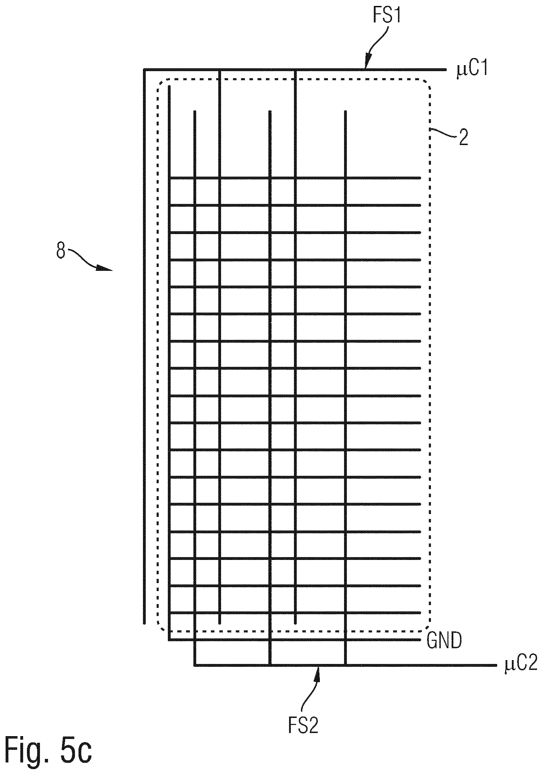

Eine mögliche Ausgestaltung und Struktur der zugehörigen Leiterbahnen FS1, FS2 und GND sind in Aufsicht in Figur 5c gezeigt, wobei die Strukturen auf unterschiedlichen, einander zugewandten Seiten der den Hohlraum 14 begrenzenden Schichten 11, 13 des Schichtaufbaus vorgesehen sind.

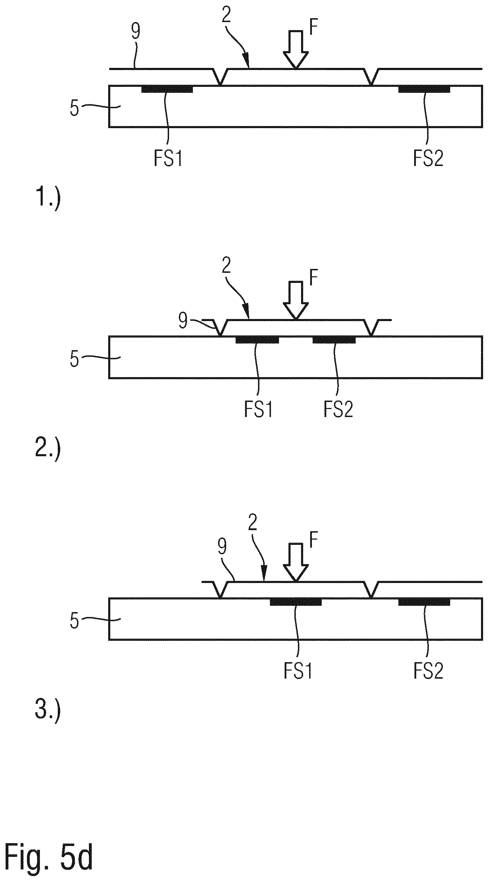

Figur 5d zeigt eine mögliche nicht-erfindungsgemäße Ausgestaltung einer redundanten Auslegung von zwei kapazitiven Betätigungsdetektionseinrichtungen, insbesondere deren Sensoren, wobei eine elastisch verformbare, leitfähige Schicht 9 als gemeinsame Elektrode in Zusammenwirken mit Elektroden FS1 und FS2, die auf dem Träger 5 angeordnet sind, jeweils Messkapazitäten ausbilden. Die auf die Schicht 9 einwirkende Betätigungskraft F im Bereich der Eingabefläche 2 verursacht deren elastische Verformung ähnlich eines Biegebalkens und sorgt für eine Veränderung der Messkapazitäten, die somit jeweils ein Maß für die Betätigungskraft F sind. Durch redundante Messung an verschiedenen sich gleichzeitig der Verformung durch die Betätigungskraft unterliegenden Stellen der Schicht 9, wird eine sichere Detektion erreicht. Je nach Platzierung der Elektroden FS1 und FS2 und in Abhängigkeit der Verformungsrichtung der Schicht 9 ist eine gleichsinnige Messung gemäß der 1.) und 2.) Ausführungsform der Figur 5d aber auch eine gegenläufige Messung gemäß der 3.) Ausführungsform der Figur 5d möglich.

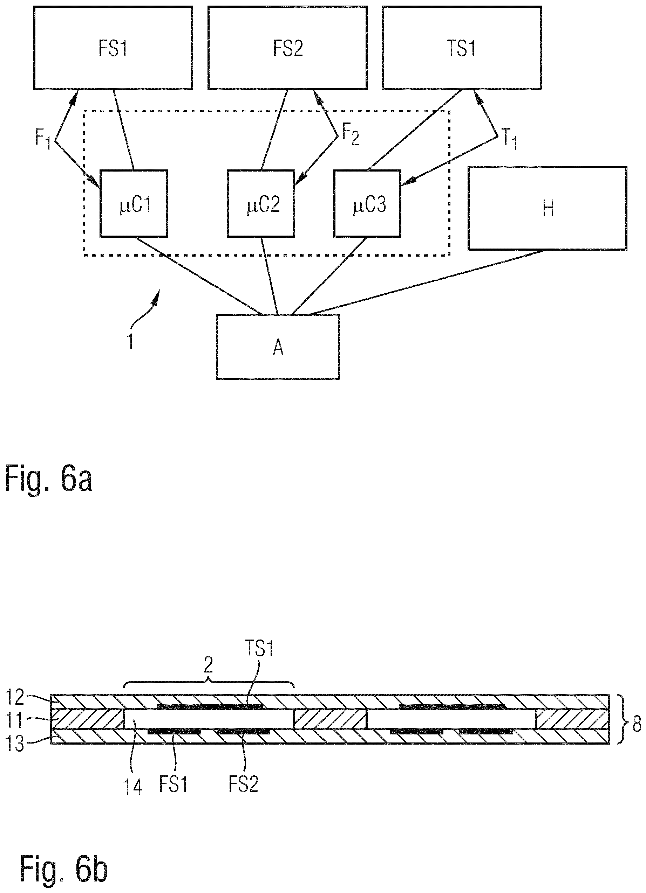

Figur 6a zeigt eine nicht-erfindungsgemäße Ausführungsform, bei der die redundante Auslegung durch zwei parallel detektierende Betätigungsdetektionseinrichtungen F1 und F2 durch eine zusätzliche Berührdetektionseinrichtung T1 ergänzt ist. Auch hier wird nur dann einer Betätigung auf der Eingabefläche 2 des Eingabegeräts 1 eine Schalt- oder Steuerfunktion durch die Auswerteinheit A zugeordnet und die Erzeugung eines haptischen Feedbacks durch die Haptikeinrichtung H initiiert, wenn durch sämtliche Detektionseinrichtungen F1, F2 und T1 eine Berührung bzw. Betätigung detektiert wurde. Eine Integration von Teilen sämtlicher Detektionseinrichtungen wird anhand der Figur 6b erläutert. Auch hier könnte die in Figur 2b gezeigte Anordnung der Kraftsensoren 3, 4 zwischen dem Träger 5 und dem Gehäuse 6 zugunsten einer integrierten Anordnung von Teilen der kapazitiven Betätigungsdetektionseinrichtung, hier den Elektroden FS1 und FS2, aber auch von Teilen der kapazitiven Berührdetektionseinrichtung, hier der Elektrode TS1 in den Schichtaufbau 8 entfallen. In der vorliegenden Ausgestaltung ist die Trägerschicht 12 elastisch verformbar ausgestaltet und erstreckt sich über einen durch die Abstandsschicht 11 definierten Hohlraum 14, der unterhalb der Eingabefläche 2 angeordnet ist und nach oben durch die Trägerschicht 12 und die dort auf der dem Hohlraum 14 zugewandten Seite aufgebrachten Elektrode TS1 begrenzt wird. Während die Elektrode TS1 einerseits der kapazitiven Berührdetektion durch die Berührdetektionseinrichtung T1 dient, erzeugt sie in Zusammenwirken mit den Elektroden FS1 und FS2, die auf der dem Hohlraum 14 zugewandten Seite der Grundschicht 13 aufgebracht sind, jeweils eine Messkapazität, deren Veränderung durch elastische Verformung der Trägerschicht jeweils ein Maß für die auf die Eingabefläche 2 einwirkende Betätigungskraft ist. Gemeinsam mit der Berührdetektion durch die ein kapazitives Messfeld erzeugende Elektrode TS1 ergibt sich somit eine dreifach redundante Auslegung der Detektionseinrichtungen F1, F2 und T1.

## Patentansprüche

1. Eingabegerät (1) aufweisend mehrere Eingabeflächen (2), mehrere Detektionseinrichtungen (T1, T2, F1, F2), die jeweils ausgelegt sind, unabhängig voneinander entweder eine Berührung der Eingabefläche (2) oder eine Betätigung der Eingabefläche (2) zu detektieren, eine Auswerteinheit (A), die ausgelegt ist, ausschließlich bei Detektion durch wenigstens zwei der Detektionseinrichtungen (T1, T2, F1, F2) dem Eingabegerät (1) bei Betätigung oder Berührung eine Schalt- oder Steuerfunktion zuzuordnen, wobei wenigstens eine Detektionseinrichtung (F1, F2) ausgelegt ist, eine Betätigung zu detektieren, wobei wenigstens die eine Detektionseinrichtung (F1, F2), die ausgelegt ist, eine Betätigung zu detektieren, eine Matrix von Kraftsensoren aufweist, und die Matrix von Kraftsensoren ausgelegt ist, einen Einwirkort der Betätigungskraft (F) zu detektieren und die Auswerteinheit (A) ausgelegt ist, in Abhängigkeit des Einwirkortes der Betätigungskraft (F) dem Eingabegerät (1) eine einwirkortspezifische Schalt- oder Steuerfunktion aus mehreren Schalt- oder Steuerfunktionen zuzuordnen,
**dadurch gekennzeichnet, dass** die mehreren Detektionseinrichtungen (T1, T2, F1, F2) in einen gemeinsamen Folienschichtaufbau (8) integriert sind und jedem Kraftsensor eine der Eingabeflächen (2) zugeordnet ist, dass zwei Detektionseinrichtungen (T1, T2) zur kapazitiven Detektion einer Berührung der Eingabefläche (2) mit mehreren elektrisch isoliert zueinander angeordneten ringförmigen oder streifenförmigen Elektroden vorgesehen sind, dass die mehreren Elektroden gemäß ihrer Zugehörigkeit zu den Berührdetektionseinrichtungen (T1, T2) in der Ausdehnungsrichtung der Eingabefläche (2) alternierend angeordnet sind, ferner durch Überwachung jeweils ein und derselben Eingabefläche (2) durch die die Berührung detektierenden Detektionseinrichtungen (T1, T2) und die die Betätigung detektierende Detektionseinrichtung (F1, F2).

2. Eingabegerät (1) gemäß Anspruch 1, wobei wenigstens die eine Detektionseinrichtungen (F1, F2), die ausgelegt ist, eine Betätigung zu detektieren, wenigstens einen kapazitiv, induktiv, resistiv und/oder optisch messenden Kraftsensor zur Detektion einer der Betätigung zugeordneten Betätigungskraft aufweist.

3. Eingabegerät (1) gemäß einem der vorhergehenden Ansprüche, wobei wenigstens die eine Detektionseinrichtung (F1, F2), die ausgelegt ist, die Betätigung zu detektieren, ferner ausgelegt ist, bei gleichzeitiger Betätigung an mehreren Einwirkorten die Einwirkorte zu detektieren, und die Auswerteinheit (A) ausgelegt ist, in Abhängigkeit der verschiedenen Einwirkorte dem Eingabegerät (1) eine spezifische Schalt- oder Steuerfunktion aus mehreren Schalt- oder Steuerfunktionen zuzuordnen.

4. Eingabegerät (1) gemäß einem der vorhergehenden Ansprüche, ferner aufweisend eine Haptikeinrichtung (H) zur Erzeugung einer haptischen Rückmeldung, und die Auswerteinheit ausgelegt ist, falls wenigstens eine der Detektionseinrichtungen (T1, T2, F1, F2), bevorzugt wenigstens zwei der Detektionseinrichtungen, eine Berührung oder Betätigung detektiert, eine haptische Rückmeldung durch die Haptikeinrichtung (H) zu bewirken.

5. Eingabegerät (1) gemäß einem der vorhergehenden Ansprüche, ferner aufweisend eine Funktionsüberwachungseinrichtung zur Überwachung der Funktion wenigstens einer der mehreren, bevorzugt aller, Detektionseinrichtungen (T1, T2, F1, F2).

6. Eingabegerät (1) gemäß dem vorhergehenden Anspruch, wobei die mehreren Detektionseinrichtungen einen gemeinsamen Sender zur Erzeugung eines oder mehrerer Detektionssignale, beispielsweise eines optischen Signals aufweisen, und die Funktionsüberwachungseinrichtung einen Empfänger für das eine oder die mehreren Detektionssignale aufweist.

7. Lenkrad (10) aufweisend ein an dem Lenkrad (10) befestigtes Eingabegerät (1) gemäß einem der vorhergehenden Ansprüche.

8. Verwendung des Eingabegeräts (1) nach einem der vorhergehenden Ansprüche 1 bis 6 in einem Kraftfahrzeug, insbesondere zur Steuerung einer Geschwindigkeitsregelungseinrichtung.

## Claims

1. Input device (1) having a plurality of input areas (2), a plurality of detection devices (T1, T2, F1, F2) which are each designed to detect either touching of the input area (2) or actuation of the input area (2) independently of one another, an evaluation unit (A) which is designed, only upon detection by at least two of the detection devices (T1, T2, F1, F2), to assign a switching or control function to the input device (1) upon actuation or touching, wherein at least one detection device (F1, F2) is designed to detect actuation, wherein at least the one detection device (F1, F2) which is designed to detect actuation has a matrix of force sensors, and the matrix of force sensors is designed to detect an action location of the actuation force (F), and the evaluation unit (A) is designed, on the basis of the action location of the actuation force (F), to assign an action-location-specific switching or control function from a plurality of switching or control functions to the input device (1),
**characterized in that** the plurality of detection devices (T1, T2, F1, F2) are integrated in a common film layer structure (8), and one of the input areas (2) is assigned to each force sensor, **in that** two detection devices (T1, T2) are provided for the purpose of capacitively detecting touching of the input area (2) using a plurality of annular or strip-type electrodes which are arranged in a manner electrically insulated from one another, **in that** the plurality of electrodes are arranged alternately in the direction of extent of the input area (2) according to their affiliation with the touch detection devices (T1, T2), also by monitoring the same input area (2) in each case by means of the detection devices (T1, T2) detecting the touching and the detection device (F1, F2) detecting the actuation.

2. Input device (1) according to Claim 1, wherein at least the one detection device (F1, F2) which is designed to detect actuation has at least one capacitively, inductively, resistively and/or optically measuring force sensor for detecting an actuation force associated with the actuation.

3. Input device (1) according to one of the preceding claims, wherein at least the one detection device (F1, F2) which is designed to detect the actuation is also designed to detect the action locations in the event of simultaneous actuation at a plurality of action locations, and the evaluation unit (A) is designed, on the basis of the various action locations, to assign a specific switching or control function from a plurality of switching or control functions to the input device (1).

4. Input device (1) according to one of the preceding claims, also having a haptic device (H) for producing haptic feedback, and, if at least one of the detection devices (T1, T2, F1, F2), preferably at least two of the detection devices, detects touching or actuation, the evaluation unit is designed to cause haptic feedback from the haptic device (H).

5. Input device (1) according to one of the preceding claims, also having a function monitoring device for monitoring the function of at least one of the plurality of detection devices (T1, T2, F1, F2), preferably of all detection devices.

6. Input device (1) according to the preceding claim, wherein the plurality of detection devices have a common transmitter for generating one or more detection signals, for example an optical signal, and the function monitoring device has a receiver for the one or more detection signals.

7. Steering wheel (10) having an input device (1) according to one of the preceding claims which is fastened to the steering wheel (10).

8. Use of the input device (1) according to one of the preceding Claims 1 to 6 in a motor vehicle, in particular for controlling a speed control device.

## Revendications

1. Appareil d'entrée (1) comportant plusieurs surfaces d'entrée (2), plusieurs dispositifs de détection (T1, T2, F1, F2) qui sont chacun conçus pour détecter indépendamment les uns des autres soit un contact avec la surface d'entrée (2), soit un actionnement de la surface d'entrée (2), une unité d'évaluation (A) qui est conçue pour associer, uniquement lors de la détection par au moins deux des dispositifs de détection (T1, T2, F1, F2), une fonction de commutation ou de commande à l'appareil d'entrée (1) en cas d'actionnement ou de contact, au moins un dispositif de détection (F1, F2) étant conçu pour détecter un actionnement, l'un au moins des dispositifs de détection (F1, F2), qui est conçu pour détecter un actionnement, comportant une matrice de capteurs de force, et la matrice de capteurs de force étant conçue pour détecter un site d'action de la force d'actionnement (F), et l'unité d'évaluation (A) étant conçue pour associer à l'appareil d'entrée (1), en fonction du site d'action de la force d'actionnement (F), une fonction de commutation ou de commande spécifique au site d'action parmi plusieurs fonctions de commutation ou de commande,
**caractérisé en ce que** les plusieurs dispositifs de détection (T1, T2, F1, F2) sont intégrés dans une structure en couches de film commune (8), et l'une des surfaces d'entrée (2) est associée à chaque capteur de force, deux dispositifs de détection (T1, T2) destinés à la détection capacitive d'un contact de la surface d'entrée (2) sont pourvus de plusieurs électrodes en forme d'anneau ou de bande qui sont disposées les unes par rapport aux autres en étant isolées électriquement, **en ce que** les plusieurs électrodes sont disposées de manière alternée dans la direction d'extension de la surface d'entrée (2) suivant leur association aux dispositifs de détection de contact (T1, T2), en outre par surveillance d'une même surface d'entrée (2) par le biais des dispositifs de détection (T1, T2) qui détectent le contact et du dispositif de détection (F1, F2) qui détecte l'actionnement.

2. Appareil d'entrée (1) selon la revendication 1, l'au moins un des dispositifs de détection (F1, F2), qui est conçu pour détecter un actionnement, comportant au moins un capteur de force à mesure capacitive, inductive, résistive et/ou optique destiné à détecter une force d'actionnement associée à l'actionnement.

3. Appareil d'entrée (1) selon l'une des revendications précédentes, l'au moins un dispositif de détection (F1, F2), qui est conçu pour détecter l'actionnement, étant en outre conçu pour détecter les sites d'action en cas d'actionnement simultané au niveau de plusieurs sites d'action, et l'unité d'évaluation (A) étant conçue pour associer une fonction de commutation ou de commande spécifique parmi plusieurs fonctions de commutation ou de commande à l'appareil d'entrée (1) en fonction des différents sites d'action.

4. Appareil d'entrée (1) selon l'une des revendications précédentes, comportant en outre un dispositif haptique (H) destiné à générer un retour haptique et l'unité d'évaluation étant conçue pour provoquer un retour haptique par le biais du dispositif haptique (H) dans le cas où l'un au moins des dispositifs de détection (T1, T2, F1, F2), de préférence deux des dispositifs de détection, détecte(nt) un contact ou un actionnement.

5. Appareil d'entrée (1) selon la revendication précédente, comportant en outre un dispositif de surveillance de fonction destiné à surveiller la fonction d'au moins un des plusieurs dispositifs de détection (T1, T2, F1, F2), de préférence tous.

6. Appareil d'entrée (1) selon l'une des revendications précédentes, les plusieurs dispositifs de détection comportant un émetteur commun destiné à générer un ou plusieurs signaux de détection, par exemple un signal optique, et le dispositif de surveillance de fonction comportant un récepteur destiné à l'un des signaux de détection ou à plusieurs signaux de détection.

7. Volant (10) comportant un appareil d'entrée (1) selon l'une des revendications précédentes, fixé au volant (10).

8. Utilisation de l'appareil d'entrée (1) selon l'une des revendications précédentes 1 à 6 dans un véhicule automobile, en particulier pour commander un dispositif de régulation de vitesse.
